# FASCICULE DE BREVET EUROPEEN

(11) **EP 3 305 042 B1**
(45) Date de publication et mention de la délivrance du brevet: **19.06.2019**
(21) Numéro de dépôt: 16725137.0
(22) Date de dépôt: 26.05.2016
(51) Int. Cl.: H05K 1/18, H05K 3/30

(54) **DISPOSITIF MID COMPRENANT AU MOINS UN COMPOSANT ÉLECTRONIQUE ET PROCÉDÉ DE MONTAGE**
MID-VORRICHTUNG MIT MINDESTENS EINER ELEKTRONISCHEN KOMPONENTE UND ZUGEHÖRIGES VERFAHREN
MID DEVICE COMPRISING AT LEAST ONE ELECTRONIC COMPONENT AND ASSEMBLY METHOD

(30) Priorité: 26.05.2015 FR 1554710
(43) Date de publication de la demande: 11.04.2018
(73) Titulaire: Valeo Vision, 93012 Bobigny Cedex (FR)
(72) Inventeur: HUE, David, 95430 Butry sur Oise (FR); ZOJCESKI, Zdravko, 92400 Courbevoie (FR)
(74) Mandataire: Valeo Vision
(86) Numéro de dépôt international: PCT/EP2016/061889
(87) Numéro de publication internationale: WO 2016/189080

(56) Documents cités:
- US-A1- 2009 059 543
- US-A1- 2011 303 644

## Description

L'invention a trait au domaine des dispositifs d'interconnexion moulés, MID, et particulièrement aux procédés de montage composants électroniques, par exemple de sources lumineuses de type diodes électroluminescentes, LED, sur un circuit électronique implémenté sur un MID. L'invention trouve son application par exemple dans le domaine des dispositifs lumineux pour véhicules automobiles.

L'utilisation de dispositifs MID (acronyme de « Molded Interconnect Device ») est particulièrement intéressante dans la construction de dispositifs lumineux pour véhicules automobiles utilisant des sources lumineuses telles que des diodes électroluminescentes, LED, des diodes électroluminescentes organiques, OLED ou des diodes laser. Un MID est un substrat moulé pouvant prendre les formes complexes et intégrant à sa surface des pistes électriquement conductrices faisant partie d'un circuit électronique. Dans sa fonctionnalité électronique, il est semblable à un circuit imprimé ou PCB. Cependant, sa forme complexe peut également servir de support pour d'autres éléments, par exemple des éléments optiques du dispositif lumineux. Le niveau d'intégration de fonctions du substrat est alors particulièrement élevé, ce qui est un avantage lors de la conception de systèmes électroniques et optiques complexes dans l'espace restreint et contraignant d'un feu de voiture automobile.

Il est connu, par exemple par le document de brevet EP 2 141 406 A2, de monter des LEDs sur un MID par une technique de soudure. Les moyens de connexion d'un LED traversent un substrat pour être soudés du côté opposé du substrat. L'implication d'une pâte à souder résulte nécessairement dans la formation d'interfaces intermétalliques à tenue mécanique fragile, et non pas dans un contact électrique et mécanique direct entre les moyens de connexion du LED et les pistes conductrices du MID.

Il est également connu de fixer des LEDs sur un MID en utilisant la soudure par refusion. En plus de la formation d'interfaces intermétalliques, ce genre de procédé risque d'endommager le substrat en matière polymère ainsi que les LEDs en conséquence des températures élevées nécessaires pour réaliser les soudures.

Le document de brevet US 2002/0006040 A1 divulgue un MID sur lequel des LEDs sont collées, et ensuite reliées aux pistes électriquement conductrices préalablement formées du MID par une technique de pontage (« wire bonding »). Le collage nécessite une métallisation préalable au nickel et à l'étain, présentant des risques de fiabilité de la liaison puisque l'étain est susceptible à la formation d'oxyde.

Le document de brevet US20090059543 A1, divulgue un dispositif d'interconnexion moulé (MID) et une procédure pour créer des pistes structurées directement au laser (LDS).

Le document de brevet US20110303644 A1, divulgue un procédé de métallisation de dispositifs tridimensionnels (MID).

L'invention a pour objectif de pallier à au moins un des problèmes posés par l'art antérieur.

Plus précisément, l'invention a pour objectif de proposer un MID portant un composant électronique tel qu'une source lumineuse, dans lequel la liaison entre les deux composants est fiable et durable dans le temps.

L'invention a pour objet un dispositif d'interconnexion moulé, MID, ayant une surface constituée d'au moins une première partie isolante et d'au moins une deuxième partie définissant une ou plusieurs pistes électriques d'un circuit électronique, la deuxième partie de surface comprenant au moins une couche métallique électriquement conductrice. Le circuit électronique comprend au moins un composant électronique, par exemple une source lumineuse. Le dispositif MID est remarquable en ce que au moins un moyen de connexion électrique du composant électronique est recouvert de ladite couche métallique du MID.

Le substrat du MID peut de préférence être fabriqué par la technique du moulage par injection dans un moule tridimensionnel d'une matière électriquement isolante. Il s'agit par exemple, et de manière non-limitative, de polyamide, de polymères, de matières céramiques ou d'oxyde d'aluminium. Le substrat peut de préférence contenir un additif métallique. Le substrat peut avantageusement être nettoyé et ses surfaces sont activées par un laser, ce qui y crée de fines rugosités. Un film mince, de préférence d'une épaisseur de 0.1 à 0.2 µm de cuivre, d'or, d'argent, de nickel ou de palladium est ensuite déposé sur les surfaces activées par laser, par exemple par évaporation sous vide ou par pulvérisation cathodique.

Le moyen de connexion électrique peut par exemple comprendre un élément du composant électronique, tel qu'une patte de connexion. Alternativement, le composant électronique peut être intégré à une grille de connexion (« leadframe »). Les connecteurs de la grille de connexion forment alors les moyens de connexion du composant électronique.

De préférence, l'au moins un moyen de connexion électrique du composant électronique peut être en contact mécanique direct avec ladite couche métallique du MID.

De manière préférée, ladite couche métallique peut comprendre du cuivre, de l'argent, du nickel ou de l'or.

Avantageusement, ladite couche métallique peut être en cuivre.

La surface du moyen de connexion électrique du composant électronique peut de préférence comprendre le même métal que ladite couche métallique. Avantageusement, le moyen de connexion peut être réalisé en ce métal.

De manière préférentielle, le composant électronique peut être une source lumineuse, notamment une diode électroluminescente, LED, une diode électroluminescente organique, OLED, ou une diode laser.

L'invention a également pour objet un dispositif lumineux pour un véhicule automobile comprenant un dispositif de pilotage de l'alimentation d'au moins une source lumineuse disposée sur un dispositif d'interconnexion moulé, MID. Le dispositif est remarquable en ce que le MID est conforme à l'invention.

L'invention a aussi pour objet un procédé de montage d'un composant électronique, par exemple d'une source lumineuse sur un dispositif d'interconnexion moulé, MID, lors de la production dudit dispositif. Le procédé est remarquable en ce qu'il comprend les étapes séquentielles suivantes :
- mise en contact d'au moins un moyen de connexion du composant électronique, ledit moyen de connexion ayant une surface comprenant un métal électriquement conducteur, avec une partie de surface du substrat du MID, ladite partie de surface étant destinée à être couverte d'une couche du même métal pour créer une piste électriquement conductrice;
- revêtement de ladite partie de surface du substrat d'au moins une couche du même métal, de façon à ce que le métal fixe le composant électronique au MID et met le composant électronique en connexion électrique avec la piste ainsi métallisée du MID.

Avantageusement, l'étape de mise en contact est destinée à mettre en contact la source lumineuse avec ladite partie de surface du substrat à un emplacement prédéterminé.
Le cas échéant, le procédé selon l'invention peut comporter, préalablement à l'étape de mise en contact, une étape de détection optique, par exemple via une caméra, d'une position d'une région émettrice de lumière de la source lumineuse, l'étape de mise en contact étant destinée à positionner la source lumineuse à l'emplacement prédéterminé de ladite partie de surface du substrat en prenant en compte la position de ladite région émettrice de lumière de la source lumineuse.

Le métal peu de préférence être du cuivre, de l'argent, du nickel ou de l'or. De manière avantageuse, le moyen de connexion comporte au moins une partie de surface en cuivre.

Le métal peut de préférence être du cuivre, et le revêtement de ladite partie de surface du substrat peut avantageusement être réalisé dans un bain de cuivrage chimique.

De préférence, le procédé peut comprendre une étape préalable de mise à disposition d'un composant électronique ayant des moyens de connexion ayant une surface comprenant ledit même métal.

Alternativement, le procédé peut comprendre les étapes préalables suivantes :
- mise à disposition d'un composant électronique ayant des moyens de connexion comprenant ledit même métal, avec un revêtement en surface d'un métal différent ;
- élimination du revêtement en surface des moyens de connexion, afin d'exposer une surface comprenant ledit même métal utilisé pour le revêtement de la partie de substrat du MID lors de l'étape de revêtement.

L'étape d'élimination du revêtement en surface des moyens de connexion du composant électronique peut de préférence comprendre une étape de polissage.

Le composant électronique lumineuse peut préférentiellement être maintenue à l'emplacement de montage sur le substrat du MID par des moyens de fixation temporaires, avant d'être fixée de manière définitive par l'étape de revêtement. Les moyens de fixation temporaires peuvent comprendre une pince ou une colle de fixation.

De préférence, le procédé selon l'invention peut comprendre une étape préalable d'activation des parties de surface du substrat du MID destinées à être revêtues de la couche de métal électriquement conductrice, l'activation étant préférentiellement réalisée par laser.

Le composant électronique peut de préférence être une source lumineuse , notamment une diode électroluminescente, LED, une diode électroluminescente organique, OLED, ou une diode laser.

Toutes les étapes du procédé selon l'invention sont avantageusement réalisées à température ambiante, de préférence à une température entre 15°C et 50°C. Plus préférentiellement, la température peut être entre 15°C et 30°C. De manière encore plus préférée, la température peut être entre 20°C et 30°C, par exemple elle peut mesurer 25°C.

Le dispositif selon l'invention présente l'avantage que la liaison entre un composant électronique et le MID dont elle fait partie ne présente pas d'interfaces intermétalliques, ce qui réduit le risque de dégradation de la liaison dans le temps, et ce qui augmente la fiabilité de la liaison. Contrairement aux procédés de montage connus dans l'art, le procédé selon l'invention est réalisé à température ambiante et évite d'exposer le MID et/ou la source lumineuse à des températures élevées, nécessaires par exemple lors d'un procédé de refusion. Ceci est particulièrement avantageux lorsqu'il s'agit de composant tels que des sources lumineuses de type diode électroluminescente, LED, diode électroluminescente organique, OLED, ou diode laser, puisque ces composants électroniques sont très sensibles à des températures élevées et risquent d'être endommagés à haute température. Le procédé permet ainsi de réduire les coûts de production en évitant la dégradation des composants utilisés. Les liaisons mécaniques et électriques réalisées par le procédé selon l'invention entre le composant électronique, par exemple la source lumineuse, et le MID sont durables par l'absence d'interfaces intermétalliques présentant notamment des risques d'oxydation.

D'autres caractéristiques et avantages de la présente invention seront mieux compris à l'aide de la description exemplaire et des dessins parmi lesquels :
- la figure 1 est un diagramme illustrant les étapes principales d'un procédé de montage selon un mode de réalisation préféré de l'invention ;
- la figure 2 est une illustration schématique d'une coupe latérale d'un dispositif selon un mode de réalisation préféré de l'invention ;

Sauf indication spécifique du contraire, des caractéristiques techniques décrites en détail pour un mode de réalisation donné peuvent être combinés aux caractéristiques techniques décrites dans le contexte d'autres modes de réalisation décrits à titre exemplaire et non limitatif.

Un dispositif d'interconnexion moulé peut se présenter sous une multitude de formes, dépendant de son utilisation finale. Il n'est donc pas utile de décrire de manière spécifique la géométrie d'un MID, et l'invention se rapporte à des MIDs de géométries diverses. Dans le cas de l'utilisation d'un MID dans un dispositif lumineux pour un véhicule automobile, la géométrie du substrat du MID peut servir de support, par exemple pour des éléments optiques, à part d'intégrer des circuits électroniques comprenant des composants électroniques tels que des sources lumineuses. A titre d'exemplaire et non limitatif, les composants électroniques décrits dans ce qui suit sont des sources lumineuses. Les sources lumineuses sont de manière connue alimentées par une source de courant interne au véhicule automobile, comme par exemple la batterie du véhicule. En général, un dispositif de pilotage de l'alimentation des sources lumineuses, incluant un convertisseur continu, est intercalé entre la source de courant et les sources à alimenter. Ces éléments ne seront pas décrits en plus de détails dans le cadre de la présente invention, et ils sont connus dans l'art.

De manière connue, le substrat d'un MID est fabriqué par la technique du moulage par injection dans un moule tridimensionnel d'une matière électriquement isolante. Il s'agit par exemple, et de manière non-limitative, de polyamide, de polymères, de matières céramiques ou d'oxyde d'aluminium. Ce substrat peut contenir un additif métallique.

Ensuite, le substrat est nettoyé et ses surfaces sont activées par un laser, ce qui y crée de fines rugosités. Un film mince, de préférence d'une épaisseur de 0.1 à 0.2 µm de cuivre, d'or, d'argent, de nickel ou de palladium est ensuite déposé sur les surfaces activées par laser, par exemple par évaporation sous vide, par pulvérisation cathodique ou par d'autres techniques en soi connues dans l'art.

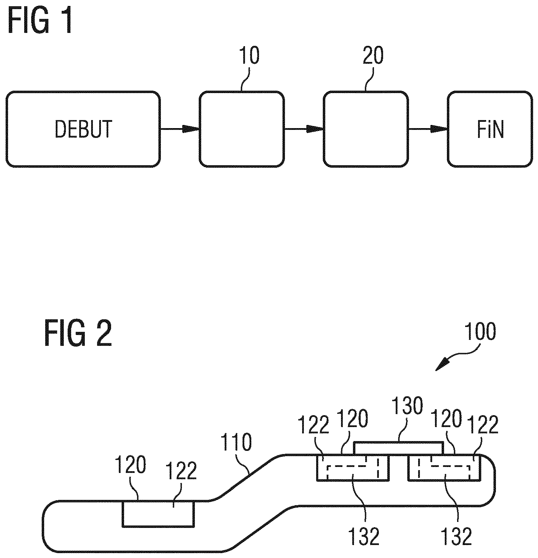

La figure 1 montre les principales étapes du procédé de montage d'une source lumineuse, telle que par exemple une LED, OLED ou diode laser, qui interviennent après l'étape d'activation par laser, qui vient d'être décrite.

Dans ce qui suit, l'exemple d'une source lumineuse de type LED sera donné sans aucune limitation de l'invention à ce type de sources. Une LED est un composant électronique semi-conducteur qui dégage de la lumière lorsqu'une tension électrique supérieure à une valeur seuil est appliquée à ses bornes. Les deux bornes du composant, ou moyens de connexions, sont en général formées par des pattes de connexion. Alternativement un composant LED peut être intégré à une grille de connexion (« leadframe »). Les connecteurs de la grille de connexion forment alors les moyens de connexion du composant LED.

Lors d'une première étape 10, la LED est placée sur le MID de façon à ce qu'au moins un de ses moyens de connexion, ou une de ses pattes, vienne en contact avec la surface du substrat destinée à être revêtues de la couche de métal électriquement conductrice. La position de la source lumineuse est définie de manière précise et le composant est maintenu en place par des pinces, par une colle de fixation ou par d'autres moyens de fixation mécanique temporaire en soi connus par l'homme du métier.

Ensuite, lors d'une étape de revêtement 20, une couche de métal électriquement conducteur est déposée sur les parties du MID qui sont destinées à constituer des pistes électriquement conductrices. On choisit de déposer une couche du métal présent à la surface des moyens de connexion du LED. Lorsqu'il s'agit de cuivre, le dépôt est de préférence réalisé à l'aide d'un bain de cuivrage chimique. De tels procédés sont réalisés à température ambiante et sont en soi connus dans l'art. La solution de cuivrage comprend par exemple du sulfate de cuivre (80g/l) et le l'acide sulfurique (180g/l). Une tension électrique est appliquée aux parties pré-métallisées du substrat du MID. Lors du passage de courant électrique à travers les parties pré-métallisées du substrat du MID, le cuivre présent dans la solution chimique y est déposé. Les parties pré-métallisées peuvent avantageusement être activées avant passage dans le bain chimique, afin d'augmenter leur pouvoir d'attraction par rapport au métal à déposer. Une telle activation est par exemple réalisée par laser. Le dépôt de la couche de métal fixe en même temps les pattes des LEDs à la piste électriquement conductrice ainsi crée sur le MID. Comme cette méthode de fixation n'implique pas de températures élevées, ni les LEDs ni le substrat du MID s'en voient détériorés et leur durabilité ainsi que leur fiabilité en restent garanties. Comme la liaison entre la piste conductrice et les moyens de connexion du LED n'implique pas d'interfaces intermétalliques, la tenue mécanique réalisée est accrue par rapport aux méthodes de liaison connues dans l'art.

Des résidus métalliques qui se déposent lors du bain chimique sur les parties du MID destinées à rester isolantes sont enlevés ultérieurement, par exemple par attaque chimique douce.

De préférence, des sources lumineuses ayant des moyens de connexion en cuivre sont utilisées pour le montage ainsi décrit. Lorsque les moyens de connexion sont cependant revêtues d'un métal ou alliage différent, par exemple pour permettre leur soudage ou leur connexion par pontage, il est préféré d'enlever ce revêtement. Ceci est réalisé par exemple par polissage mécanique en soi connu dans l'art, afin d'exposer une surface en cuivre avant d'appliquer le procédé selon l'invention.

Alternativement au cuivre, d'autres métaux comme l'argent, l'or ou le nickel peuvent être utilisés par substitution. Des méthodes de dépôts de ces métaux à température ambiante sont connues dans l'art.

La figure 2 montre da manière schématique une coupe latérale d'un dispositif MID 100 selon un mode de réalisation préféré de l'invention, résultant notamment du procédé de montage selon l'invention.

Le dispositif 100 comprend une première partie électriquement isolante 110 qui est réalisé lors du moulage du substrat. Une deuxième partie 120 définit une ou plusieurs pistes électriques. Cette partie 120 comprend au moins une couche métallique 122 électriquement conductrice. Sur l'illustration donnée, la couche 122 est logée dans un évidement du substrat du MID, et forme une surface à raz avec la partie isolante 110. Alternativement, la couche peut également venir s'ajouter sur la partie isolante 110 en élévation par rapport à celle-ci. Une source lumineuse, par exemple une LED 130 ayant des moyens de connexion électrique 132 est montée sur une piste conductrice du MID. Les moyens de connexion 132, ayant en surface de préférence le même métal électriquement conducteur que celui dont la couche 122 est formée, sont en contact mécanique et électrique direct avec, et recouverts de ladite couche métallique 122 du MID. Le métal en question est de préférence du cuivre. Alternativement, il peut s'agir d'argent, de nickel ou d'or.

## Revendications

1. Dispositif d'interconnexion moulé (100), MID, ayant une surface constituée d'au moins une première partie isolante (110) et d'au moins une deuxième partie (120) définissant une ou plusieurs pistes électriques d'un circuit électronique, la deuxième partie de surface (120) comprenant au moins une couche métallique électriquement conductrice (122), dans lequel le circuit électronique comprend au moins un composant électronique, par exemple une source lumineuse (130), **caractérisé en ce que** au moins un moyen de connexion électrique (132) du composant électronique(130) est recouvert de ladite couche métallique (122) du MID.

2. Dispositif selon la revendication 1, **caractérisé en ce que** l'au moins un moyen de connexion électrique (132) du composant électronique (130) est en contact mécanique direct avec ladite couche métallique (122) du MID.

3. Dispositif selon une des revendications 1 ou 2, **caractérisé en ce que** ladite couche métallique comprend du cuivre, de l'argent, du nickel ou de l'or.

4. Dispositif selon une des revendications 1 ou 2, **caractérisé en ce que** ladite couche métallique est en cuivre.

5. Dispositif selon une quelconque des revendications 1 à 4, **caractérisé en ce que** la surface du moyen de connexion électrique (132) du composant électronique (130) comprend le même métal que ladite couche métallique (122).

6. Dispositif selon une quelconque des revendications 1 à 5, **caractérisé en ce que** le composant électronique est une source lumineuse, notamment une diode électroluminescente, LED, une diode électroluminescente organique, OLED, ou une diode laser.

7. Dispositif lumineux pour un véhicule automobile comprenant un dispositif de pilotage de l'alimentation d'au moins une source lumineuse disposée sur un dispositif d'interconnexion moulé, MID, **caractérisé en ce que** le MID est conforme à une des revendications 1 à 6.

8. Procédé de montage d'un composant électronique, par exemple d'une source lumineuse (130) sur un dispositif d'interconnexion moulé (100), MID, lors de la production dudit dispositif, **caractérisé en ce que** le procédé comprend les étapes séquentielles suivantes :
- mise en contact d'au moins un moyen de connexion (132) du composant électronique, ledit moyen de connexion ayant une surface comprenant un métal électriquement conducteur, avec une partie de surface du substrat du MID, ladite partie de surface étant destinée à être couverte d'une couche du même métal pour créer une piste électriquement conductrice (10);
- revêtement de ladite partie de surface du substrat d'au moins une couche (122) dudit même métal, de façon à ce que le métal le composant électronique (130) au MID et met le composant électronique en connexion électrique avec la piste ainsi métallisée du MID (20).

9. Procédé selon la revendication 8, **caractérisé en ce que** le métal est du cuivre, l'argent, du nickel ou de l'or.

10. Procédé selon l'une des revendications 8 ou 9, **caractérisé en ce que** le métal est du cuivre, et **en ce que** le revêtement de ladite partie de surface du substrat est réalisé dans un bain de cuivrage chimique.

11. Procédé selon une quelconque des revendications 8 à 10, **caractérisé en ce que** le procédé comprend une étape préalable de mise à disposition composant électronique ayant des moyens de connexion ayant une surface comprenant ledit même métal.

12. Procédé selon une quelconque des revendications 8 à 10, **caractérisé en ce que** le procédé comprend les étapes préalables suivantes :
- mise à disposition d'un composant électronique ayant des moyens de connexion comprenant ledit même métal, avec un revêtement en surface d'un métal différent ;
- élimination du revêtement en surface des moyens de connexion, afin d'exposer une surface comprenant ledit même métal utilisé pour le revêtement de la partie de substrat du MID lors de l'étape (20).

13. Procédé selon une quelconque des revendications 8 à 12, caractérisé en que le composant électronique est maintenu à l'emplacement de montage sur le substrat du MID par des moyens de fixation temporaires, avant d'être fixé de manière définitive par l'étape de revêtement (20).

14. Procédé selon une quelconque des revendications 8 à 13, **caractérisé en ce qu'**il comprend une étape préalable d'activation des parties de surface du substrat du MID destinées à être revêtues de la couche de métal électriquement conductrice, préférentiellement par laser.

15. Procédé selon une quelconque des revendications 8 à 14, **caractérisé en ce que** le composant électronique est une source lumineuse, notamment une diode électroluminescente, LED, une diode électroluminescente organique, OLED, ou une diode laser.

## Patentansprüche

1. Spritzgegossene Verbindungsvorrichtung (100), MID, die eine Oberfläche hat, die aus mindestens einem ersten isolierenden Teil (110) und aus mindestens einem zweiten Teil (120), der eine oder mehrere elektrische Bahnen einer elektronischen Schaltung definiert, besteht, wobei der zweite Oberflächenteil (120) mindestens eine elektrisch leitfähige Metallschicht (122) umfasst, wobei die elektronische Schaltung mindestens ein elektronisches Bauteil, beispielsweise eine Lichtquelle (130), umfasst, **dadurch gekennzeichnet, dass** mindestens ein elektrisches Anschlussmittel (132) des elektronischen Bauteils (130) mit der Metallschicht (122) der MID überzogen ist.

2. Vorrichtung nach Anspruch 1, **dadurch gekennzeichnet, dass** mindestens ein elektrisches Anschlussmittel (132) des elektronischen Bauteils (130) in unmittelbarem mechanischem Kontakt mit der Metallschicht (122) der MID ist.

3. Vorrichtung nach einem der Ansprüche 1 oder 2, **dadurch gekennzeichnet, dass** die Metallschicht Kupfer, Silber, Nickel oder Gold umfasst.

4. Vorrichtung nach einem der Ansprüche 1 oder 2, **dadurch gekennzeichnet, dass** die Metallschicht aus Kupfer ist.

5. Vorrichtung nach einem der Ansprüche 1 bis 4, **dadurch gekennzeichnet, dass** die Oberfläche des elektrischen Anschlussmittels (132) des elektronischen Bauteils (130) das gleiche Metall umfasst wie die Metallschicht (122).

6. Vorrichtung nach einem der Ansprüche 1 bis 5, **dadurch gekennzeichnet, dass** das elektronische Bauteil eine Lichtquelle ist, insbesondere eine Leuchtdiode, LED, oder eine organische Leuchtdiode, OLED, oder eine Laserdiode.

7. Leuchtvorrichtung für ein Kraftfahrzeug, umfassend eine Vorrichtung zur Ansteuerung der Versorgung mindestens einer Lichtquelle, die auf einer spritzgegossenen Verbindungsvorrichtung, MID, angeordnet ist, **dadurch gekennzeichnet, dass** die MID einem der Ansprüche 1 bis 6 entspricht.

8. Verfahren zur Montage eines elektronischen Bauteils, beispielsweise einer Lichtquelle (130), auf einer spritzgegossenen Verbindungsvorrichtung (100), MID, bei der Herstellung der Vorrichtung, **dadurch gekennzeichnet, dass** das Verfahren die folgenden sequenziellen Schritte umfasst:
- Kontaktieren mindestens eines Anschlussmittels (132) des elektronischen Bauteils, wobei das Anschlussmittel eine Oberfläche hat, die ein elektrisch leitfähiges Metall umfasst, mit einem Oberflächenteil des Substrats der MID, wobei der Oberflächenteil dazu bestimmt ist, mit einer Schicht aus dem gleichen Metall bedeckt zu werden, um eine elektrisch leitfähige Bahn zu schaffen (10) ;
- Überziehen des Oberflächenteils des Substrats mit mindestens einer Schicht (122) aus dem gleichen Metall, so dass das Metall das elektronische Bauteil (130) an der MID und das elektronische Bauteil elektrisch an die so metallisierte Bahn der MID (20) anschließt.

9. Verfahren nach Anspruch 8, **dadurch gekennzeichnet, dass** das Metall Kupfer, Silber, Nickel oder Gold ist.

10. Verfahren nach einem der Ansprüche 8 oder 9, **dadurch gekennzeichnet, dass** das Metall Kupfer ist und dass das Überziehen des Oberflächenteils des Substrats in einem Bad zur chemischen Verkupferung ausgeführt wird.

11. Verfahren nach einem der Ansprüche 8 bis 10, **dadurch gekennzeichnet, dass** das Verfahren einen vorherigen Schritt des Bereitstellens eines elektronischen Bauteils umfasst, das Anschlussmittel hat, die eine Oberfläche haben, die das gleiche Metall umfasst.

12. Verfahren nach einem der Ansprüche 8 bis 10, **dadurch gekennzeichnet, dass** das Verfahren die folgenden vorherigen Schritte umfasst:
- Bereitstellen eines elektronischen Bauteils, das Anschlussmittel hat, die das gleiche Metall umfassen, mit einem Oberflächenüberzug aus einem unterschiedlichen Metall;
- Beseitigung des Oberflächenüberzugs der Anschlussmittel, damit eine Oberfläche freigelegt wird, die das gleiche Metall umfasst, das für den Überzug des Substratteils der MID beim Schritt (20) verwendet wurde.

13. Verfahren nach einem der Ansprüche 8 bis 12, **dadurch gekennzeichnet, dass** das elektronische Bauteil am Montageort auf dem Substrat der MID von temporären Befestigungsmitteln gehalten wird, bevor es durch den Überzugsschritt (20) endgültig befestigt wird.

14. Verfahren nach einem der Ansprüche 8 bis 13, **dadurch gekennzeichnet, dass** es einen vorherigen Schritt der Aktivierung der Oberflächenteile des Substrats der MID umfasst, die dazu bestimmt sind, mit der elektrisch leitfähigen Metallschicht überzogen zu werden, bevorzugt durch Laser.

15. Verfahren nach einem der Ansprüche 8 bis 14, **dadurch gekennzeichnet, dass** das elektronische Bauteil eine Lichtquelle ist, insbesondere eine Leuchtdiode, LED, oder eine organische Leuchtdiode, OLED, oder eine Laserdiode.

## Claims

1. Moulded interconnect device (100), MID, having a surface formed by at least one first insulating portion (110) and by at least one second portion (120) defining one or more electrical tracks of an electronic circuit, the second surface portion (120) comprising at least one electrically conductive metal layer (122), wherein the electronic circuit comprises at least one electronic component, for example a light source (130), **characterized in that** at least one electrically connecting means (132) of the electronic component (130) is covered with said metal layer (102) of the MID.

2. Device according to Claim 1, **characterized in that** the at least one electrically connecting means (132) of the electronic component (130) makes direct mechanical contact with said metal layer (122) of the MID.

3. Device according to one of Claims 1 and 2, **characterized in that** said metal layer comprises copper, silver, nickel or gold.

4. Device according to one of Claims 1 and 2, **characterized in that** said metal layer is made of copper.

5. Device according to any one of Claims 1 to 4, **characterized in that** the surface of the electrically connecting means (132) of the electronic component (130) comprises the same metal as said metal layer (122).

6. Device according to any one of Claims 1 to 5, **characterized in that** the electronic component is a light source, in particular a light-emitting diode, LED, an organic light-emitting diode, OLED, or a laser diode.

7. Luminous device for a motor vehicle, comprising a device for driving the supply of at least one light source placed on a moulded interconnect device, MID, **characterized in that** the MID is according to one of Claims 1 to 6.

8. Method for mounting an electronic component, for example a light source (130) on a moulded interconnect device (100), MID, during the production of said device, **characterized in that** the method comprises the following sequential steps:
- bringing into contact at least one connecting means (132) of the electronic component, said connecting means having a surface comprising an electrically conductive metal, with a surface portion of the substrate of the MID, said surface portion being intended to be covered with a layer of the same metal in order to create an electrically conductive track (10) ;
- coating said surface portion of the substrate with at least one layer (122) of said same metal, so that the metal the electronic component (130) to the MID and places the electronic component in electrical connection with the track thus metallized of the MID (20) .

9. Method according to Claim 8, **characterized in that** the metal is copper, silver, nickel or gold.

10. Method according to one of Claims 8 and 9, **characterized in that** the metal is copper, and **in that** the coating of said surface portion of the substrate is carried out in a chemical copper-plating bath.

11. Method according to any one of Claims 8 to 10, **characterized in that** the method comprises a prior step of providing an electronic component having connecting means having a surface comprising said same metal.

12. Method according to any one of Claims 8 to 10, **characterized in that** the method comprises the following prior steps:
- providing an electronic component having connecting means comprising said same metal, with a surface coating of a different metal;
- removing the surface coating from the connecting means, in order to expose a surface comprising said same metal used for the coating of the substrate portion of the MID in step (20).

13. Method according to any one of Claims 8 to 12, **characterized in that** the electronic component is held in the mounting site on the substrate of the MID by temporary fastening means, before being definitively fastened by the coating step (20).

14. Method according to any one of Claims 8 to 13, **characterized in that** it comprises a prior step of activating those surface portions of the substrate of the MID which are intended to be coated with the layer of electrically conductive metal, preferably by laser.

15. Method according to any one of Claims 8 to 14, **characterized in that** the electronic component is a light source, in particular a light-emitting diode, LED, an organic light-emitting diode, OLED, or a laser diode.
